Europäisches Patentamt

**European Patent Office**

**Office européen des brevets**

(11) Numéro de publication: **0 263 729 B1**

(12) **FASCICULE DE BREVET EUROPEEN**

(45) Date de publication de fascicule du brevet: **19.08.92** (51) Int. Cl.⁵: **H01L 23/36**, H05K 7/20

(21) Numéro de dépôt: **87401999.5**

(22) Date de dépôt: **08.09.87**

(54) **Dispositif de connexion d'un commutateur statique de puissance précâblé de pattes conductrices souples.**

(30) Priorité: **09.09.86 FR 8612597**

(43) Date de publication de la demande:
**13.04.88 Bulletin 88/15**

(45) Mention de la délivrance du brevet:
**19.08.92 Bulletin 92/34**

(84) Etats contractants désignés:
**DE ES GB IT**

(56) Documents cités:
**EP-A- 0 101 335**
**EP-A- 0 170 022**

**IBM TECHNICAL DISCLOSURE BULLETIN, vol. 25, no. 4, septembre 1982, pages 1954-1956, New York, US; J.C. EDWARDS: "Chip attachment to tape and cable"**

(73) Titulaire: **REGIE NATIONALE DES USINES RE-NAULT**
**Boîte postale 103 8-10 avenue Emile Zola**
**F-92109 Boulogne-Billancourt(FR)**

(72) Inventeur: **Le Paillier, Patrick**
**6, rue Gabrielle**
**F-92140 Clamart(FR)**

## Description

L'invention se rapporte à un dispositif de connexion d'un commutateur statique de puissance précâblé de pattes conductrices souples avec, d'une part, un circuit électronique de commande et, d'autre part, des charges de puissance. En particulier, elle concerne la connexion des transistors de puissance équipés du "Tape Automatic Bonding" (T.A.B.) dans des boîtiers hermétiques d'électronique hybride à haute fiabilité et à connecteurs intégrés, employés notamment dans l'automobile.

Une technique couramment utilisée actuellement pour câbler un transistor de puissance dans un boîtier hermétique consiste à déposer la puce de silicium directement sur un radiateur destiné à assurer le transfert thermique, avec ou sans isolation électrique, et à le câbler par liaison à fil (voire bonding en vocable anglo-saxon) sur le substrat supportant le circuit électronique de commande et sur les pistes conductrices de puissance du connecteur du boîtier. Cette technique suppose la maîtrise des procédés de "bonding" des puces de silicium, en particulier de "bonding" gros fil pour la liaison de puissance. Cette liaison à fil fait généralement appel à un ou deux fils d'aluminium reliant par soudure ultra-sonique une extrémité de piste d'aluminium déposée sur la puce de silicium et une languette métallique revêtue de nickel ou de nickel-or servant de patte rigide du transistor ou de languette du connecteur.

La mise au point de cette technique est très délicate et nécessite une protection efficace contre les pollutions au niveau des soudures sur le silicium.

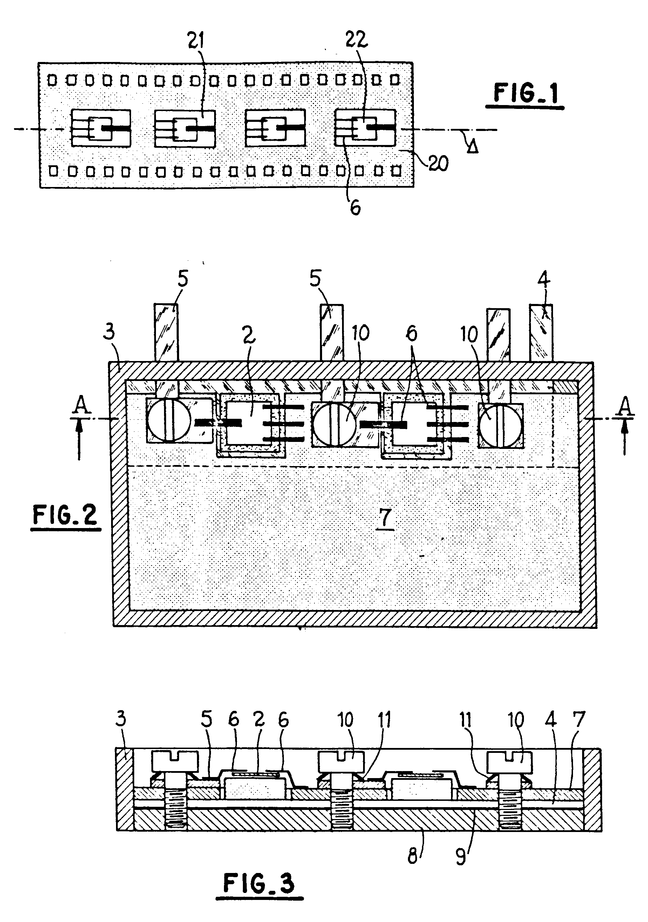

Il existe une technique beaucoup plus récente de précâblage des pièces de silicium dite de "Tape Automatic Bonding" (T.A.B.) et qui est utilisée dans l'invention. Selon cette technique, on utilise un ruban souple conducteur 20 représenté sur la figure 1 comportant une multitude de fenêtres 21 alignées selon l'axe Δ du ruban, de sorte que l'on soude, par thermo-compression, une puce 22 sur les pistes conductrices de chaque fenêtre du ruban. Pour cette opération de soudage, les puces sont préalablement équipées de dômes d'alliage métallique sur leurs zones terminales de connexion (opération de "bumping"). Après séparation de sa fenêtre-support, par découpe, la puce de silicium est dotée de pattes souples 6 et peut être collée et soudée, par thermo-compression, dans un boîtier hermétique contenant le circuit de commande. Ce type de TAB sur film monocouche est actuellement employé pour câbler des circuits intégrés.

Cette technique de précâblage des puces silicium présente de nombreux avantages par rapport à la technique de liaison à fil classique. Les pattes souples qui équipent chaque puce son en cuivre étamé facile à souder sur tout support étamé. Leurs caractéristiques mécaniques et électriques sont meilleures que celles du fil d'aluminium et elles assurent des liaisons plus fiables. Les puces de silicium ainsi précâblées sont totalement passivées, résistent mieux aux pollutions et sont testables plus facilement avant tout montage dans un boîtier.

Le but de la présente invention est de réaliser la connexion d'un circuit intégré de puissance précâblé en T.A.B. avec, d'une part, un circuit électronique de commande et, d'autre part, des pistes conductrices du circuit de puissance, en limitant au minimum le nombre de points de connexion et en assurant le transfert thermique vers un radiateur.

Pour cela, le dispositif de connexion, objet de l'invention, est caractérisé par le fait qu'il comporte une languette métallique d'alimentation placée sous la puce du circuit intégré de puissance, ladite puce, le substrat du circuit de commande et les pistes conductrices du circuit de puissance étant mécaniquement solidaires entre eux, et par le fait que ladite languette est en contact thermique avec un radiateur situé sur la face de la languette opposée à celle qui porte la puce du circuit intégré de puissance, le substrat du circuit de commande et les pistes conductrices du circuit de puissance, et destiné à l'évacuation des calories produites lors du fonctionnement du circuit intégré.

Selon une autre caractéristique, la languette est solidaire, d'une part, de la puce du circuit intégré de puissance par collage et, d'autre part, du substrate du circuit de commande et des pistes conductrices du circuit de puissance par des liaisons mécaniques rigides proches de la puce afin de limiter les dilatations différentielles entre les points de soudure du TAB.

D'autres caractéristiques et avantages de l'invention apparaîtront à la lumière de la description qui suit, illustrée par les figures suivantes qui outre le figure 1 déjà mentionnnée, représentent :
- figure 2 : une vue de dessus d'un dispositif de connexion de plusieurs transistors de puissance, selon l'invention,
- figure 3 : une vue en coupe transversale du même dispositif.

Sur les figures 2 et 3 est représenté un exemple non limitatif de réalisation d'un dispositif de connexion de deux circuits intégrés de puissance 2, équipés de pattes conductrices souples 6 selon la technologie TAB, avec un circuit électronique de commande 7, d'une part, et les pistes conductrices 4 et 5 du circuit de puissance, d'autre part, ces circuits intégrés de puissance pouvant être des transistors, placés dans un boîtier hermétique 3 (ouvert sur le dessus pour la clarté du dessin).

Ce dispositif, selon l'invention comporte une languette métallique 4 placée sous les puces 2 de silicium des circuits de puissance, cette languette 4 étant solidaire mécaniquement à la fois des puces 2 et du substrat du circuit électronique de commande 7 des circuits de puissance et des pistes conductrices 5 du circuit de puissance. Cette liaison mécanique peut être réalisée par collage entre la puce 2 et la languette 4 et par une vis isolée 10 associée à un ressort 11 entre la languette et le substrat 7 et la piste 5. Les pattes souples 6 de chaque puce 2 sont soudées aux pistes conductrices du substrat du circuit de commande 7 et aux pistes conductrices du circuit de puissance 5. S'agissant de circuits intégrés de puissance, il est prévu un radiateur 8, en cuivre ou en aluminium par exemple, destiné à évacuer les calories apparaissant en cours de fonctionnement de ces circuits intégrés de puissance. Pour assurer le transfert thermique entre les puces 2 et le radiateur 8, la languette 4 doit être en contact thermique avec le radiateur, par exemple par pression de la partie de la languette 4 située à côté de la puce 2 et du radiateur 8, par exemple au moyen du ressort 11.

Pour des raisons d'isolation électrique, il peut être nécessaire de placer une plaquette de matériau isolant 9 entre la languette 4 et le radiateur 8, ce matériau étant cependant bon conducteur de la chaleur.

L'invention peut aussi s'appliquer au dépôt direct d'une puce de silicium, précâblée selon la technologie TAB, sur les pistes d'un circuit de puissance en tôle découpée comprenant les lamelles 4 et 5 comme celui d'un bloc de feux d'automobile par exemple.

**Revendications**

1. Dispositif de connexion d'au moins une puce de circuit intégré de puissance, précâblée de pattes conductrices souples avec, d'une part, un circuit électronique de commande sur un substrat et, d'autre part, des pistes conductrices du circuit de puissance, caractérisé en ce qu'il comporte une languette métallique (4) d'alimentation placée sous la puce (2) du circuit intégré de puissance, ladite puce (2), le substrat du circuit de commande (7) et les pistes conductrices du circuit de puissance (5) étant mécaniquement solidaires entre eux, et en ce que ladite languette (4) est en contact thermique avec un radiateur (8) situé sur la face de la languette (4) opposée à celle qui porte la puce (2) du circuit intégré de puissance, le substrat du circuit de commande (7) et les pistes conductrices (5) du circuit de puissance, et destiné à l'évacuation des calories produites lors du fonctionnement du circuit intégré.

2. Dispositif selon la revendication 1, caractérisé en ce que la languette (4) est solidaire, d'une part, de la puce (2) du circuit de puissance par collage et, d'autre part, du substrat du circuit de commande (7) et des pistes conductrices (5) du circuit de puissance par liaisons mécaniques rigides.

3. Dispositif selon la revendication 2, caractérisé en ce que les liaisons mécaniques sont réalisées par une vis isolée associée à un ressort (11).

4. Dispositif selon l'une des revendications précédentes, pour un circuit intégré de puissance (2) réalisé à partir d'une puce de silicium dont la face inférieure sert d'électrode du circuit de puissance, caractérisé en ce qu'il comporte une plaquette (9) de matériau isolant électriquement placée entre la languette (4) et le radiateur (8).

**Claims**

1. Device for the connection of at least one chip of an integrated power circuit prewired with flexible conductive leads with, on the one hand, an electronic control circuit on a substrate and, on the other hand, with the conductive tracks of the power circuit, characterized in that it comprises a metal supply tongue (4) disposed below the chip (2) of the integrated power circuit, this chip (2), the substrate of the control circuit (7) and the conductive tracks of the power circuit (5) being mechanically rigid with one another and in that the tongue (4) is in thermal contact with a dissipator (8) disposed on the surface of the tongue (4) opposite that bearing the chip (2) of the integrated power circuit, the substrate of the control circuit (7) and the conductive tracks (5) of the power circuit and adapted to eliminate the heat generated during the operation of the integrated circuit.

2. A device as claimed in claim 1, characterized in that the tongue (4) is rigid, on the one hand, with the chip (2) of the power circuit by adhesion and, on the other hand, with the substrate of the control circuit (7) and the conductive tracks (5) of the power circuit via rigid mechanical connections.

3. A device as claimed in claim 2, characterized in that the mechanical connections are formed by an insulated screw associated with a spring (11).

4. A device as claimed in one of the preceding claims, for an integrated power circuit (2) formed from a silicon chip whose lower surface acts as an electrode of the power circuit, characterized in that it comprises a plate (9) of electrically insulating material disposed between the tongue (4) and the dissipator (8).

**Patentansprüche**

1. Verbindungsvorrichtung wenigstens eines Chips eines integrierten Leistungsschaltkreises, der mit biegsamen, leitenden Anschlüssen versehen ist, mit einerseits einem elektronischen Steuerschaltkreis auf einem Substrat und mit andererseits den Leiterbahnen des Leistungsschaltkreises, dadurch gekennzeichnet, daß sie eine metallische Anschlußfahne (4) aufweist, die unterhalb des Chips (2) des integrierten Leistungsschaltkreises angeordnet ist, wobei der Chip (2), das Substrat des Steuerschaltkreises (7) und die Leiterbahnen des Leistungsschaltkreises (5) mechanisch fest miteinander verbunden sind und daß die Fahne (4) im thermischen Kontakt mit einem Wärmeabstrahler (8) steht, der auf derjenigen Seite der Anschlußfahne (4) angeordnet ist, die der Seite gegenüberliegt, welche den Chip (2) des integrierten Leistungsschaltkreises, das Substrat des Steuerschaltkreises (7) und die Leiterbahnen (5) des Leistungsschaltkreises trägt und der zur Abstrahlung der während des Betriebes des integrierten Schaltkreises entwickelten Wärmemenge dient.

2. Vorrichtung nach Anspruch 1, dadurch gekennzeichnet, daß die Fahne (4) einerseits mit dem Chip (2) des Leistungsschaltkreises durch Verklebung verbunden ist und andererseits mit dem Substrat des Steuerschaltkreises (7) und den Leiterbahnen (5) des Leistungsschaltkreises durch steife mechanische Verbindungen verbunden ist.

3. Vorrichtung nach Anspruch 1, dadurch gekennzeichnet, daß die mechanischen Verbindungen aus einer isolierten, einer Feder (11) zugeordneten Schraube bestehen.

4. Vorrichtung nach einem der vorhergehenden Ansprüche, für einen integrierten Leistungsschaltkreis (2), der aus einem Silizium-Chip besteht, dessen untere Seite als Elektrode des Leistungsschaltkreises dient, dadurch gekennzeichnet, daß sie ein Plättchen (9) aus elektrisch isolierendem Material aufweist, das zwischen der Fahne (4) und dem Wärmeabstrahler (8) angeordnet ist.

FIG.1

FIG.2

FIG.3